# EUROPEAN PATENT SPECIFICATION

(11) **EP 4 455 696 B1**
(45) Date of publication and mention of the grant of the patent: **02.09.2026**
(21) Application number: 22909833.0
(22) Date of filing: 14.12.2022
(51) Int. Cl.: G01R 31/367, G01R 31/3842, G01R 31/387, G01R 31/3828, G01R 31/3835

(54) **BATTERY SOC ESTIMATION METHOD AND RELATED DEVICE**
VERFAHREN ZUR SCHÄTZUNG DES BATTERIE-SOC UND ZUGEHÖRIGE VORRICHTUNG
PROCÉDÉ D'ESTIMATION DE SOC DE BATTERIE ET DISPOSITIF ASSOCIÉ

(30) Priority: 24.12.2021 CN 202111602389
(43) Date of publication of application: 30.10.2024
(73) Proprietor: Great Wall Motor Company Limited, Baoding, Hebei 071000 (CN)
(72) Inventor: ZHANG, Junwei, Baoding, Hebei 071000 (CN); KANG, Wenrong, Baoding, Hebei 071000 (CN)
(74) Representative: Klunker IP Patentanwälte PartG mbB
(86) International application number: PCT/CN2022/138886
(87) International publication number: WO 2023/116519

(56) References cited:
- CN-A- 104 714 181
- CN-A- 106 597 307
- CN-A- 106 646 265
- CN-A- 106 707 187
- CN-A- 109 613 432
- CN-A- 109 669 131
- CN-A- 110 861 534
- CN-A- 110 967 636
- CN-A- 112 034 366
- CN-A- 112 946 496
- CN-A- 115 113 069
- JP-A- 2013 057 537
- JP-A- 2014 220 236
- JP-A- 2015 025 686
- JP-A- 2020 043 084
- US-A1- 2012 310 563
- US-A1- 2013 275 067
- US-A1- 2014 303 915
- US-A1- 2015 355 285
- US-A1- 2021 263 107

## Description

### TECHNICAL FIELD

The present invention relates to the technical field of batteries, and more specifically to a method for estimating a state of charge of a battery and a related device, and a vehicle comprising the device.

### BACKGROUND

In a battery management system, the general correction method for the State of Charge (SOC, also known as a charging state or a remaining capacity, refers to the ratio of the remaining dischargeable capacity of a battery to the fully charged capacity of the battery after being used for a period of time or a long period of time, which usually expressed as a percentage) is a static open circuit voltage (OCV) correction and a full charged correction. However, if the battery is not left idle or fully charged for a long time, it will lead to the inability to correct SOC for a long time, resulting in significant errors. Therefore, the correction of the SOC during battery charging and discharging operation is particularly important.

Recently, in order to calculate the SOC value of the battery during charging and discharging operation, the open circuit voltage (OCV) of the battery during operation can be determined based on the DC resistance of the battery, the corresponding SOC target value can then be queried through the OCV-SOC table, or the closed circuit voltage (CCV)-SOC table can be used during battery charging to query the corresponding SOC target value. However, due to various errors during calculating the SOC, such as sampling errors of measuring apparatuses and table lookup errors, etc. If the SOC target value is completely used to correct the SOC of the battery, there will be issues of over corrections and frequent repeated corrections, leading to SOC jitter.

JP 2013 057537 A discloses a battery management apparatus performing a SOC integration processing which allows a control part to obtain an estimated SOC by current integration for integrating the current flowing in a battery in a time, a voltage measurement processing which measures the OCV of the battery, a reference range configuration processing which configures a wider reference range inversely proportional to the rate of change of the OCV with the SOC in the region of measurement values of the OCV on the basis of the OCV-SOC correlation, and a SOC adjustment processing which allows the estimated SOC obtained by the SOC integration processing to be shifted to the side of reference range when the estimated SOC is out of the reference range, and allows the estimated SOC not to be shifted when the estimated SOC is in the reference range.

JP 2020 043084 A discloses a battery management device that determines an SOC range indicating the SOC of a secondary battery, and comprises a central processing unit that determines an overlapping range of an SOC range R1 determined by a current integration method and an SOC range R2 determined by a voltage reference method in a stage where the SOC range R1 is determined by the current integration method, as a new SOC range R3.

US 2012/310563 A1 discloses a SOC computation system in which a first estimated SOC is output based on an estimated open voltage of a secondary battery. A second estimated SOC is output based on the result obtained by integrating the measured current of the secondary battery and the upper limit of the error of the measured current and the capacity of the secondary battery. A third estimated SOC is output based on the result obtained by integrating the measured current and the lower limit of the error of the measured current and the battery capacity. A fourth estimated SOC is output based on the result obtained by integrating the measured current and the battery capacity. The fourth estimated SOC is output as a SOC within the period of the predetermined period.

CN 112 034 366 A discloses an SOC dynamic compensation method and an electronic system, the method is applied to electronic systems with batteries, and the method comprises the following steps: obtaining a current sampling error value of the battery; integrating the current sampling error value in the current time period to obtain an integrated first error value; obtaining a voltage sampling error value of the battery under OCV sampling; obtaining an estimated SOC error value as a second error value according to the voltage sampling error value; and dynamically compensating the SOC value of the current battery according to the first error value and the second error value to obtain a compensated SOC value.

### SUMMARY

### TECHNICAL PROBLEM

It is an object of the present invention to provide a method for estimating the SOC of a battery and a related device for estimating the SOC of a battery, and a vehicle comprising the device so as to solve the problem of SOC jitter caused by errors in the calculation process of the SOC in existing technologies.

### TECHNICAL SOLUTIONS

The object is achieved by the feature of the independent claim 1 regarding the method for estimating a SOC of a battery and by the feature of the independent claim 7 regarding the device for estimating the SOC of a battery, and by the feature of the independent claim 10 regarding the vehicle comprising the device.

### BENEFICIAL EFFECTS

The present invention provides the method and the corresponding device for estimating the state of charge of a battery, and a vehicle comprising the device; which first obtains a current state of charge value of the battery; a voltage of the battery is then sampled to obtain a current measured voltage of the battery; a state of charge target value of the battery is calculated at the current measured voltage; a correction error of the state of charge target value is then obtained to determine a state of charge error range based on the correction error and the state of charge target value; and the current state of charge value is finally corrected according to a size relationship between the state of charge error range and the current state of charge value. Through the above solution, the present application can consider the correction error in the state of charge calculation process when correcting the state of charge, and expand the uncorrected range of the current state of charge value based on the correction error, therefore the problem of the state of charge jitter caused by frequent repeated corrections are avoided and the accuracy of state of charge estimation is ensured.

### BRIEF DESCRIPTION OF THE DRAWINGS

In order to explain the present invention more clearly, a brief introduction regarding the accompanying drawings that need to be used for describing the present invention or the prior art is given below.
FIG. 1 is an implementation flowchart of a method for estimating an SOC of a battery;
FIG. 2 is a schematic curve diagram of a charging current, a charging voltage, and true values of SOC obtained through off-line calibration of a battery;
FIG. 3 is a schematic delineation diagram of an SOC error range;
FIG. 4 is a structural schematic diagram of a device for estimating an SOC of a battery; and
FIG. 5 is a schematic diagram of an electronic apparatus.

### DETAILED DESCRIPTION

In the description below, specific details such as specific system architecture, technology, etc. are presented for illustration rather than qualification in order to fully understand the present invention.

In order to make the purpose, technical solution and advantages of the present invention more clear, the following will be illustrated with the attached drawings.

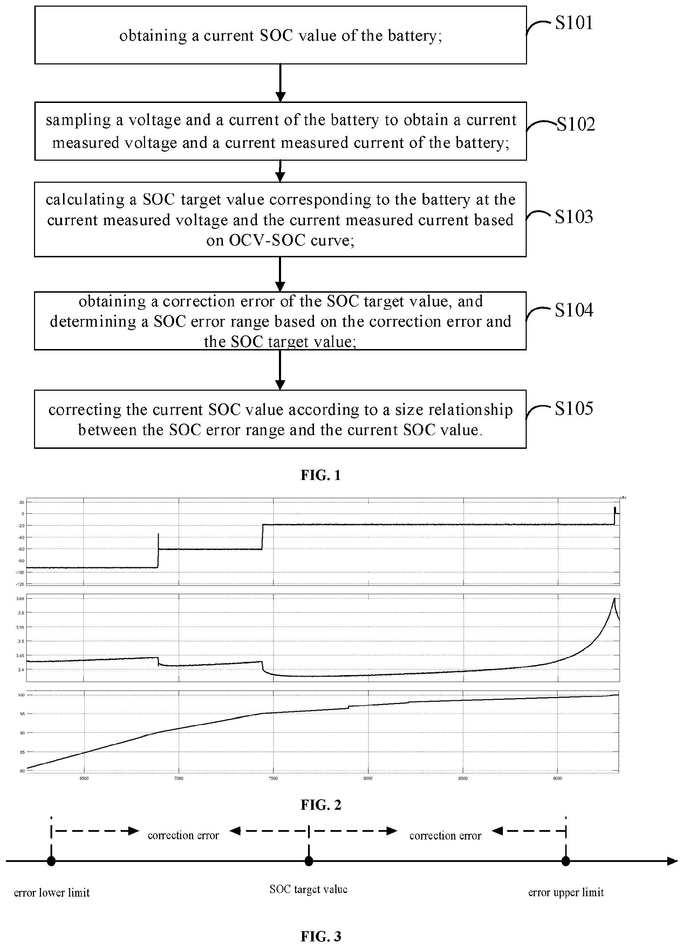

As shown in FIG. 1, which shows an implementation flowchart of a method for estimating an SOC of a battery, and the details are as follows:
In a step S101, obtaining a current SOC value of the battery.

The executing body (electronic device) of the embodiment can be a battery management system.

In a step S102, sampling a voltage of the battery to obtain a current measured voltage of the battery.

In the embodiment, the battery management system uses a voltage measuring device to measure the voltage of the battery and obtain the current measured voltage; and the battery management system can also use the voltage measuring device to measure the current of the battery to obtain the current measured current.

In a step S103, calculating an SOC target value of the battery at the current measured voltage.

The battery management system calculates and updates the current SOC value of the battery in real time during the operation of the battery. There are errors in the SOC value, and the SOC value needs to be corrected by the battery management system from time to time. Because the conventional static open circuit voltage (OCV) correction method can only detect the open circuit voltage when the battery is standing, the lithium battery in the operating state for a long time will accumulate large errors.

In order to solve the above problems, two methods for calculating the SOC can be used in the embodiment during battery operation, the details are as follows:
In a first implementation flow, the step S103 includes:
calculating an open circuit voltage of the battery according to a formula *U_{ocv}=U_{c}+i*DCR,* in which *U_{ocv}* represents the open circuit voltage, *U_{c}* represents the current measured voltage, *i* represents the current measured current of the battery, and *DCR* represents a direct circuit internal resistance of the battery; and
determining a state of charge value at the open circuit voltage based on an OCV-SOC correspondence relationship, and taking the state of charge value as the state of charge target value.

Specifically, when the battery is in operating, the battery management system can use the DC internal resistance DCR to calculate the open circuit voltage *U_{ocv}* at the current measured current and the current measured voltage, and then determine the SOC value at the current open circuit voltage *U_{ocv}* by looking up the table, so as to realize the SOC correction during the battery operation.

The OCV-SOC correspondence relationship can be a two-dimensional graph with SOC values in horizontal coordinates and *U_{ocv}* in vertical coordinates, or it can be a table with SOC values, *U_{ocv}* and the correspondence relationship of the SOC and *U_{ocv}.*

Specifically, the OCV-SOC table includes the correspondence relationship between the open circuit voltage and the SOC values at a certain temperature. Before querying the table, the battery management system firstly obtains the current battery temperature, then locks the OCV-SOC table at the current battery temperature, and determines the SOC target value at the current open circuit voltage by querying the OCV-SOC table.

In a second implementation flow, the step S103 includes:
determining the state of charge target value at the current measured voltage according to a preset CCV-SOC table in case that the battery is in a charging state, and the preset CCV-SOC table includes a correspondence relationship between the measured voltage and the state of charge value.

Specifically, the preset CCV-SOC table includes the correspondence relationship between the measured voltage and the SOC value at a certain temperature and at a certain current ratio. Before querying the table, the battery management system firstly obtains the current temperature of the battery, the locks the CCV-SOC table at the current temperature, and determines the SOC target value at the current measured closed circuit voltage (CCV) by querying the CCV-SOC table.

For example, since the cell factory can only provide CCV-SOC tables with several current ratios, the CCV-SOC table corresponding to 0.1C of current ratios with better accuracy can be selected for table lookup operation. In other implementations, other current ratios corresponding to the CCV-SOC table can also be selected, which is not limited herein.

In a step S104, obtaining a correction error of the SOC target value, and determining an SOC error range based on the correction error and the SOC target value.

Specifically, the method determines the SOC error range by obtaining the correction errors of the SOC target value and the SOC true value.

In the claimed method, for obtaining the correction error of the SOC target value, the step S104 includes:
obtaining true SOC values of the battery at different measured voltages obtained by off-line calibration;
obtaining historical SOC target values of the battery at different measured voltages in historical charge and discharge cycles;
for any one of the measured voltages, taking a difference between each of the historical SOC target values and each of the true SOC values of the battery at the measured voltages as an error value corresponding to the measured voltage; and
averaging the error value corresponding to each measured voltage to obtain the correction error.

Specifically, during the calculation of the SOC, there may be errors in several links, one of which is the DCR error, due to the DC internal resistance DCR of the battery is the value provided by the cell factory, there is often some error in the actual application process; therefore, using the SOC target value calculated by DCR provided by the cell factory to correct the current SOC value may cause SOC jitter problems caused by over correction or frequent correction.

Another error during the calculation of the SOC is the CCV-SOC table /OCV-SOC table error. The CCV-SOC table or OCV-SOC table are data provided by the cell factory, which may cause certain errors in the application process due to the difference in the actual temperature and actual current ratio of the battery.

In order to avoid the above errors, the staff can periodically calibrate the battery off-line to determine the relationship between the voltage, the current and the SOC true value of the battery during the entire charging cycle. As shown in FIG. 2, the comparison curves of the charging current, the charging voltage and the SOC true value are shown in FIG. 2. The top curve in FIG. 2 is the curve corresponding to the charging current, where the abscissa is time and the ordinate is the charging current; the middle curve is the curve corresponding to the charging voltage, where the abscissa is the time, and the ordinate is the charging voltage; the bottom curve is the curve corresponding to the SOC true value, where the abscissa is the time, and the ordinate is the SOC true value. It can be seen from FIG. 2 that off-line calibration can determine the SOC true value of the battery at each charging voltage.

The battery management system is also used to store the SOC target values at different measured voltages in the first N charge and discharge cycles at the current moment, and then the SOC target value at different measured voltages in any one of charge and discharge cycles can be selected, and the SOC true value and SOC target value at the same measured voltage can be queried to determine the error value between the SOC true value at each measured voltage and the SOC target value, and then all the error values are averaged to obtain the correction error.

In another implementation process for obtaining the correction error of the SOC target value, which process on its own is however not forming part of the claimed subject-matter, the step S104 includes:
obtaining a sampling error of a voltage measuring device;
determining a voltage error range of a target measured voltage based on the sampling error, in which the target measured voltage is a measured voltage corresponding to a preset state of charge value;
determining an error range corresponding to the preset state of charge value based on the voltage error range; and
determining a correction error of the state of charge target value according to the error range of the preset state of charge value and the preset state of charge value.

Here, the sampling error of the measuring device is also an important factor causing the correction error of the SOC during the calculation of the SOC, so the correction error can be determined to be considered based on the sampling error of the measuring device, and the process is detailed as follows:
First, the battery management system can take any SOC value as the baseline and use the correction error of the SOC as the correction error of all SOCs. After the preset SOC value and the target measured voltage corresponding to the preset SOC value are determined, the battery management system subtracted the target measured voltage from the sampling error to obtain the error lower limit of the voltage in the voltage error range, and added the target measured voltage to the sampling error to obtain the error upper limit of voltage in the voltage error range; the upper limit of the SOC corresponding to the error upper limit of the voltage and the lower limit of the SOC corresponding to the error lower limit of the voltage are then obtained by querying the CCV-SOC table, so as to determine the error range of the preset SOC value. Finally, the first SOC error is obtained by subtracting the upper limit of the SOC from the preset SOC value, and the second SOC error is obtained by subtracting the lower limit of the SOC from the preset SOC value. The larger value of the first SOC error and the second SOC error is taken as the correction error corresponding to the SOC target value.

Specifically, the currents of different SOC segments are different during the battery charging process, as shown in Table 1, and the current ratios of different SOC segments are shown in Table 1. It can be seen from Table 1 that the current of the SOC in the 95%-100% segment is 0.1C, and the CCV-SOC table corresponding to 0.1C is usually used for CCV table querying. Therefore, SOC values within the 95%-100% segment are selected as the preset SOC value in the present invention.

**Table 1**

| SOC | Current |
|---|---|
| 95%<SOC≤100% | 0.33C |
| 90%<SOC≤95% | 0.5C |
| 85%<SOC≤90% | 0.5C |
| 80%<SOC≤85% | 0.8C |
| 70%<SOC≤80% | 0.8C |
| 60%<SOC≤70% | 1.05C |
| 50%<SOC≤60% | 1.05C |
| 40%<SOC≤50% | 1.2C |
| 30%<SOC≤40% | 1.2C |
| 20%<SOC≤30% | 1.2C |
| 10%<SOC≤20% | 1.2C |
| 0%<SOC≤5% | 1.2C |
| SOC≤0% | 0.1C |

In another implementation process for obtaining the correction error of the SOC target value, the step S104 includes:
obtaining true SOC values of the battery at different measured voltages obtained by off-line calibration;
obtaining historical SOC target values of the battery at different measured voltages in historical charge and discharge cycles;
for any one of the measured voltages, taking a difference between each the historical SOC target values and each of the true SOC values of the battery at the measured voltages as an error value corresponding to the measured voltage;
averaging the error value corresponding to each measured voltage to obtain a first correction error;
obtaining a sampling error of a voltage measuring device;
determining a voltage error range of a target measured voltage based on the sampling error, in which the target measured voltage is a measured voltage corresponding to a preset SOC value;
determining an error range corresponding to the preset SOC value based on the voltage error range;
determining a second correction error according to the error range of the preset SOC value and the preset SOC value; and
selecting a greater value from the first correction error and the second correction error, and taking the greater value as a correction error of the SOC target value.

Specifically, the maximum error during the calculation of the SOC can be obtained through the above method in the embodiment, so as to further expand the uncorrected range of the current SOC value through the maximum error, the SOC jitter problem caused by frequent repeated correction is avoided, and the SOC estimation accuracy is ensured.

In the implementation process, the step S104 may further include:
obtaining an error lower limit of the SOC error range by subtracting the correction error from the SOC target value; and
obtaining an error upper limit of the SOC error range by adding the correction error to the SOC target value.

In the embodiment, FIG. 3 shows schematic delineation diagram of an SOC error range. As shown in FIG. 3, the SOC error range of SOC target value is delimited with SOC target value as the center of the circle and the correction error as the radius. If the current SOC value is within the SOC error range, it indicates that the current SOC value is correctly calculated and does not need to be corrected; otherwise, the current SOC value is needed to be corrected.

In a step S105, correcting the current SOC value according to a size relationship between the SOC error range and the current SOC value.

In one possible implementation, the SOC error range includes an error upper limit and an error lower limit; The specific implementation process of the step S105 includes:
correcting the current SOC value to the error lower limit in case that the current SOC value exceeds the SOC error range and the current SOC value is less than the error lower limit;
correcting the current SOC value to the error upper limit in case that the current SOC value exceeds the SOC error range and the current SOC value is greater than the error upper limit; and
remaining the current SOC value being not corrected in case that the current SOC value is within the SOC error range.

Here, in case that the current SOC value exceeds the SOC error range, and the current SOC value is greater than the error upper limit of the SOC, and the difference between the current SOC value and the error upper limit is greater than the second preset error difference, that is, the difference between the current SOC estimated value and the upper limit of the SOC error is larger; therefore, if the correction of the current SOC value to the error upper limit of the SOC is strong, the SOC jitter problem will be occurred. Therefore, the average value of the current SOC value and the error upper limit can be calculated and the average value can be used to correct the current SOC value.

Accordingly, in case that the current SOC value exceeds the SOC error range, and the current SOC value is less than the error lower limit, and the difference between the current SOC value and the error lower limit is greater than the first preset error difference, that is, the difference between the current SOC value and the error lower limit is larger; therefore, if the correction of the current SOC value to the error lower limit of the SOC is strong, the SOC jitter problem will be occurred. Therefore, the average value of the current SOC value and the error lower limit can be calculated and the average value can be used to correct the current SOC value.

In case that the difference between the current SOC value and the error lower limit is greater than the first preset error difference, or the difference between the current SOC value and the error upper limit is greater than the second preset error difference, the duration of the last N sampling periods of the current sampling period is shortened. The SOC value is gently corrected to the SOC target range by increasing the number of corrections to avoid SOC value from jittering; where N is a natural number greater than zero.

As can be seen from the above, the present invention first obtains a current SOC value of the battery; a voltage of the battery is then sampled to obtain a current measured voltage of the battery; an SOC target value of the battery is calculated at the current measured voltage; a correction error of the SOC target value is then obtained to determine an SOC error range based on the correction error and the SOC target value; and the current SOC value is finally corrected according to a size relationship between the SOC error range and the current SOC value. Through the above solution, the present application can consider the correction error in the SOC calculation process when correcting the SOC, and expand the uncorrected range of the current SOC value based on the correction error, therefore the problem of the SOC jitter caused by frequent repeated corrections are avoided and the accuracy of SOC estimation is ensured.

It should be understood that the sequence number of the above steps does not imply the order of execution, and that the order of execution of each process shall be determined by its function and internal logic, and shall not constitute any limitation on the implementation process of the present invention.

The following is an electronic device implementing the present invention, for details not described in detail, reference may be made to the corresponding method above.

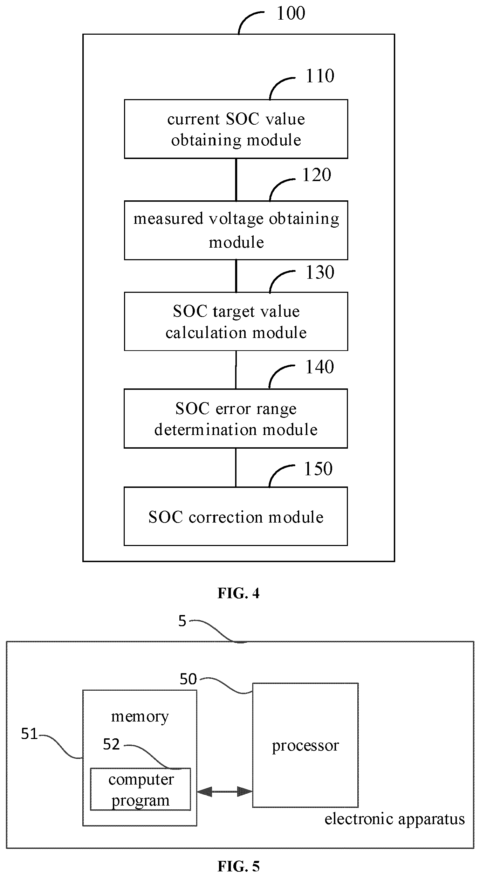

FIG. 4 shows the structural schematic diagram of the electronic device 100 for estimating an SOC of a battery. For the purpose of illustration, only the parts related to the present invention are shown in detail as follows:
As shown in FIG. 4, the electronic device 100 for estimating the SOC of the battery includes:
a current SOC value obtaining module 110, which is configured for obtaining a current SOC value of the battery;
a measured voltage obtaining module 120, which is configured for sampling a voltage of the battery to obtain a current measured voltage of the battery;
an SOC target value calculation module 130, which is configured for calculating an SOC target value of the battery at the current measured voltage;
an SOC error range determination module 140, which is configured for obtaining a correction error of the SOC target value, and determining an SOC error range based on the correction error and the SOC target value; and
an SOC correction module 150, which is configured for correcting the current SOC value according to a size relationship between the SOC error range and the current SOC value.

In one possible embodiment, the SOC target value calculation module 130 is specifically configured for:
calculating an open circuit voltage of the battery according to a formula *U_{ocv}=U_{c}+i*DCR,* where *U_{ocv}* represents the open circuit voltage, *U_{c}* represents the current measured voltage, *i* represents the current measured current of the battery, and *DCR* represents a direct circuit internal resistance of the battery; and
determining an SOC value at to the open circuit voltage based on an OCV-SOC correspondence relationship, and taking the SOC value as the SOC target value.

In one possible embodiment, the SOC target value calculation module 130 is specifically configured for:
determining the SOC target value at the current measured voltage according to a preset CCV-SOC table in case that the battery is in a charging state, in which the preset CCV-SOC table includes a correspondence relationship between the measured voltage and the SOC value.

In one possible embodiment, the SOC error range determination module 140 includes a first correction error obtaining unit configured for:
obtaining true SOC values of the battery at different measured voltages obtained by off-line calibration;
obtaining historical SOC target values of the battery at different measured voltages in historical charge and discharge cycles;
for any one of the measured voltages, taking a difference between each of the historical SOC target values and each of the true SOC values of the battery at the measured voltages as an error value corresponding to the measured voltage; and
averaging the error value corresponding to each measured voltage to obtain the correction error.

In one possible implementation, on its own not forming part of the claimed subject-matter, the SOC error range determination module 140 includes a second correction error obtaining unit configured for:
obtaining a sampling error of a voltage measuring device;
determining a voltage error range of a target measured voltage based on the sampling error, in which the target measured voltage is a measured voltage corresponding to a preset SOC value;
determining an error range corresponding to the preset SOC value based on the voltage error range; and
determining the correction error of the SOC target value according to the error range of the preset SOC value and the preset SOC value.

In one possible embodiment, the SOC error range determination module 140 includes a third correction error obtaining unit configured for:
obtaining true SOC values of the battery at different measured voltages obtained by off-line calibration;
obtaining historical SOC target values of the battery at different measured voltages in historical charge and discharge cycles;
for any one of the measured voltages, taking a difference between the historical SOC target values and the true SOC values of the battery at the measured voltages as an error value corresponding to the measured voltage;
averaging the error value corresponding to each measured voltage to obtain a first correction error;
obtaining a sampling error of a voltage measuring device;
determining a voltage error range of a target measured voltage based on the sampling error, in which the target measured voltage is a measured voltage corresponding to a preset SOC value;
determining an error range corresponding to the preset SOC value based on the voltage error range;
determining a second correction error according to the error range of the preset SOC value and the preset SOC value; and
selecting a greater value from the first correction error and the second correction error, and taking the greater value as a correction error of the SOC target value.

In one possible embodiment, the SOC error range includes an error lower limit and an error upper limit; the SOC correction module 150 is specifically configured for:
correcting the current SOC value to the error lower limit in case that the current SOC value exceeds the SOC error range and the current SOC value is less than the error lower limit;
correcting the current SOC value to the error upper limit in case that the current SOC value exceeds the SOC error range and the current SOC value is greater than the error upper limit; and
remaining the current SOC value being not corrected in case that the current SOC value is within the SOC error range.

It should be noted that the technical means and technical effects not specified in the description of the electronic device of the present invention can be referred to the corresponding technical means and technical effects of the method of the present invention.

As can be seen from the above, the present invention first obtains a current SOC value of the battery; a voltage of the battery is then sampled to obtain a current measured voltage of the battery; an SOC target value of the battery is calculated at the current measured voltage; a correction error of the SOC target value is then obtained to determine an SOC error range based on the correction error and the SOC target value; and the current SOC value is finally corrected according to a size relationship between the SOC error range and the current SOC value. Through the above solution, the present invention can consider the correction error in the SOC calculation process when correcting the SOC, and expand the uncorrected range of the current SOC value based on the correction error, therefore the problem of the SOC jitter caused by frequent repeated corrections are avoided and the accuracy of SOC estimation is ensured.

FIG. 5 is a schematic diagram of an electronic apparatus. As shown in FIG. 5, the electronic apparatus 5 includes a processor 50, a memory 51, and a computer program 52 stored in the memory 51 and capable of running on the processor 50. The steps in the above method for estimating the SOC of the battery are implemented when the processor 50 executes the computer program 52, such as steps 101 to 105 shown in FIG. 1. Alternatively, the processor 50 implements the functions of the modules/units in the above device embodiments when executing the computer program 52, such as the functions of modules 110 to 150 as shown in FIG. 4.

Illustratively, the computer program 52 may be segmented into one or more modules/units, and the one or more modules/units are stored in the memory 51 and executed by the processor 50 to complete/implement the scheme provided in the present application. The one or more modules/units may be a series of computer program instruction segments capable of performing a specific function, which is used to describe the execution process of the computer program 52 in the electronic apparatus 5. For example, the computer program 52 can be segmented into modules 110 to 150 as shown in FIG. 4.

The electronic apparatus 5 may include, but is not limited to, a processor 50, a memory 51. It may be understood by those skilled in the art that FIG. 5 is only an example of an electronic apparatus 5 and does not constitute a limitation of the electronic apparatus 5, which may include more or fewer parts than shown, or some combination of parts, or different parts, for example, the electronic device may also include an input/output device, a network access device, a bus, etc.

The so called processor 50 can be CPU (Central Processing Unit), and can also be other general purpose processor, DSP (Digital Signal Processor), ASIC (Application Specific Integrated Circuit), FGPA (Field-Programmable Gate Array), or some other programmable logic devices, discrete gate or transistor logic device, discrete hardware component, etc. The general purpose processor can be a microprocessor, or alternatively, the processor can also be any conventional processor and so on.

The memory 51 can be an internal storage unit of the electronic apparatus 5, such as a hard disk or a memory of the electronic apparatus 5. The memory 51 can also be an external storage device of the measuring device 10, such as a plug-in hard disk, a SMC (Smart Media Card), a SD (Secure Digital) card, a FC (Flash Card) equipped on the electronic apparatus 5. Further, the memory 51 may include both the internal storage unit and the external storage device of the electronic apparatus 5, either. The memory 51 is configured to store the computer programs, and other procedures and data needed by the electronic apparatus 5 for determining wellbore cross-sectional shape. The memory 51 can also be configured to storing data that has been output or being ready to be output temporarily.

The present invention also provides a vehicle which includes the electronic device described above.

## Claims

1. A method for estimating a state of charge, SOC, of a battery executed by an electronic device, the method comprising:
(S101) obtaining a current SOC value of the battery;
(S102) sampling a voltage and a current of the battery to obtain a current measured voltage and a current measured current of the battery;
(S103) calculating a SOC target value of the battery at the current measured voltage;
(S104) obtaining a correction error of the SOC target value, and determining the SOC error range based on the correction error and the SOC target value; and
(S105) correcting the current SOC value according to a size relationship between a SOC error range and the current SOC value;
**characterized in that**
the step of (S104) obtaining a correction error of the SOC target value comprises:
obtaining true SOC values of the battery at different measured voltages obtained by off-line calibration;
obtaining historical SOC target values of the battery at different measured voltages in historical charge and discharge cycles;
for any one of the measured voltages, taking a difference between each of the historical SOC target values and each of the true SOC values of the battery at the measured voltages as an error value at the measured voltage; and
averaging the error value at each measured voltage to obtain the correction error of the SOC target value.

2. The method according to claim 1, wherein the step of (S103) calculating the SOC target value of the battery at the current measured voltage comprises one of (a) and (b):
(a) calculating an open circuit voltage, OCV, of the battery according to a formula *U_{ocv}=U_{c}+i*DCR,* wherein *U_{ocv}* represents the OCV, *U_{c}* represents the current measured voltage, *i* represents the current measured current of the battery, and *DCR* represents a direct circuit internal resistance of the battery; and determining a SOC value at the OCV based on an OCV-SOC correspondence relationship, and taking the SOC value as the SOC target value; and
(b) determining the SOC target value at the current measured voltage according to a preset CCV-SOC table in case that the battery is in a charging state, wherein the preset CCV-SOC table comprises a correspondence relationship between the measured closed circuit voltage, CCV, and the SOC value.

3. The method according to claim 1, wherein the step of determining the SOC error range comprises:
obtaining an error lower limit of the SOC error range by subtracting the correction error from the SOC target value; and
obtaining an error upper limit of the SOC error range by adding the correction error to the SOC target value.

4. The method according to claim 1, wherein the SOC error range comprises an error lower limit and an error upper limit;
the step of (S105) correcting the current SOC value according to the size relationship between the SOC error range and the current SOC value comprises:
correcting the current SOC value to the error lower limit in case that the current SOC value exceeds the SOC error range and the current SOC value is less than the error lower limit;
correcting the current SOC value to the error upper limit in case that the current SOC value exceeds the SOC error range and the current SOC value is greater than the error upper limit; and
remaining the current SOC value being not corrected in case that the current SOC value is within the SOC error range.

5. The method according to claim 4, wherein the step of (S105) correcting the current SOC value according to the size relationship between the SOC error range and the current SOC value further comprises:
calculating an average value of the current SOC value and the error lower limit in case that the current SOC value exceeds the SOC error range, the current SOC value is less than the error lower limit and a difference between the current SOC value and the error lower limit is greater than a first preset error difference, and correcting the current SOC value using the average value; and
calculating an average value of the current SOC value and the error upper limit in case that the current SOC value exceeds the SOC error range, the current SOC value is greater than the error upper limit, and a difference between the current SOC value and the error upper limit is greater than a second preset error difference, and correcting the current SOC value using the average value.

6. The method according to claim 5, wherein the step of (S105) correcting the current SOC value according to the size relationship between the SOC error range and the current SOC value further comprises:
shortening a duration of last N sampling periods of a current sampling period in case that the difference between the current SOC value and the error lower limit is greater than the first preset error difference, or the difference between the current SOC value and the error upper limit is greater than the second preset error difference, wherein the N is a natural number greater than zero.

7. An electronic device (100) for estimating a state of charge, SOC, of a battery, the device (100) comprising:
a current SOC value obtaining module (110), configured for obtaining a current SOC value of the battery;
a measured voltage obtaining module (120), configured for sampling a voltage and a current of the battery to obtain a current measured voltage and a current measured current of the battery;
a SOC target value calculation module (130), configured for calculating a SOC target value of the battery at the current measured voltage;
a SOC error range determination module (140), configured for obtaining a correction error of the SOC target value, and determining the SOC error range based on the correction error and the SOC target value; and
a SOC correction module (150), configured for correcting the current SOC value according to a size relationship between a SOC error range and the current SOC value,
**characterized in that**
the SOC error range determination module (140) comprises a correction error obtaining unit configured for:
obtaining true SOC values of the battery at different measured voltages obtained by off-line calibration;
obtaining historical SOC target values of the battery corresponding to different measured voltages in historical charge and discharge cycles;
for any one of the measured voltages, taking a difference between each of the historical SOC target values and each of the true SOC values of the battery at the measured voltage as an error value corresponding to the measured voltage; and
averaging the error value corresponding to each measured voltage to obtain the correction error of the SOC target value.

8. The electronic device (100) according to claim 7, wherein the SOC target value calculation module (130) is specifically configured for one of (a) and (b):
(a) calculating an open circuit voltage, OCV, of the battery according to a formula *U_{ocv}=U_{c}+i*DCR,* wherein *U_{ocv}* represents the OCV, *U_{c}* represents the current measured voltage, *i* represents the current measured current of the battery, and *DCR* represents a direct circuit internal resistance of the battery; and determining a SOC value corresponding to the OCV based on an OCV-SOC correspondence relationship, and taking the SOC value as the SOC target value; and
(b) determining the SOC target value corresponding to the current measured voltage according to a preset CCV-SOC table in case that the battery is in a charging state, wherein the preset CCV-SOC table comprises a correspondence relationship between the measured closed circuit voltage, CCV, and the SOC value.

9. The electronic device (100) according to claim 7, wherein the SOC error range comprises an error lower limit and an error upper limit;
the SOC correction module is specifically configured for:
correcting the current SOC value to the error lower limit in case that the current SOC value exceeds the SOC error range and the current SOC value is less than the error lower limit;
correcting the current SOC value to the error upper limit in case that the current SOC value exceeds the SOC error range and the current SOC value is greater than the error upper limit; and
remaining the current SOC value being not corrected in case that the current SOC value is within the SOC error range.

10. A vehicle, comprising the electronic device (100) according to any one of claims 7-9.

## Patentansprüche

1. Verfahren zum Schätzen eines Ladezustands, SOC, einer Batterie, ausgeführt durch eine elektronische Vorrichtung, wobei das Verfahren aufweist:
(S101) Erhalten eines aktuellen SOC-Werts der Batterie;
(S102) Abtasten einer Spannung und eines Stroms der Batterie, um eine aktuell gemessene Spannung und einen aktuell gemessenen Strom der Batterie zu erhalten;
(S103) Berechnen eines SOC-Zielwerts der Batterie bei der aktuell gemessenen Spannung;
(S104) Erhalten eines Korrekturfehlers des SOC-Zielwerts und Bestimmen des SOC-Fehlerbereichs auf Grundlage des Korrekturfehlers und des SOC-Zielwerts; und
(S105) Korrigieren des aktuellen SOC-Werts gemäß einem Größenverhältnis zwischen einem SOC-Fehlerbereich und dem aktuellen SOC-Wert;
**dadurch gekennzeichnet, dass**
der Schritt des (S104) Erhaltens eines Korrekturfehlers des SOC-Zielwerts aufweist:
Erhalten von wahren SOC-Werten der Batterie bei verschiedenen gemessenen Spannungen, die durch Offline-Kalibrierung erhalten werden;
Erhalten von historischen SOC-Zielwerten der Batterie bei verschiedenen gemessenen Spannungen in historischen Lade- und Entladezyklen;
für jede der gemessenen Spannungen, Heranziehen einer Differenz zwischen jedem der historischen SOC-Zielwerte und jedem der wahren SOC-Werte der Batterie bei den gemessenen Spannungen als Fehlerwert bei der gemessenen Spannung; und
Mitteln des Fehlerwerts bei jeder gemessenen Spannung, um den Korrekturfehler des SOC-Zielwerts zu erhalten.

2. Verfahren nach Anspruch 1, wobei der Schritt des (S103) Berechnens des SOC-Zielwerts der Batterie bei der aktuell gemessenen Spannung eines von (a) und (b) aufweist:
(a) Berechnen einer Leerlaufspannung, OCV, der Batterie gemäß einer Formel *U_{ocv}=U_{c}+i*DCR,* wobei *U_{ocv}* die OCV repräsentiert, *U_{c}* die aktuell gemessene Spannung repräsentiert, *i* den aktuell gemessenen Strom der Batterie repräsentiert und *DCR* einen Gleichstrom-Innenwiderstand der Batterie repräsentiert; und Bestimmen eines SOC-Werts bei der OCV auf Grundlage einer OCV-SOC-Entsprechungsbeziehung und Heranziehen des SOC-Werts als den SOC-Zielwert; und
(b) Bestimmen des SOC-Zielwerts bei der aktuell gemessenen Spannung gemäß einer voreingestellten CCV-SOC-Tabelle für den Fall, dass sich die Batterie in einem Ladezustand befindet, wobei die voreingestellte CCV-SOC-Tabelle eine Entsprechungsbeziehung zwischen der gemessenen Spannung unter Last, CCV, und dem SOC-Wert aufweist.

3. Verfahren nach Anspruch 1, wobei der Schritt des Bestimmens des SOC-Fehlerbereichs aufweist:
Erhalten einer Fehleruntergrenze des SOC-Fehlerbereichs durch Subtrahieren des Korrekturfehlers von dem SOC-Zielwert; und
Erhalten einer Fehlerobergrenze des SOC-Fehlerbereichs durch Addieren des Korrekturfehlers zu dem SOC-Zielwert.

4. Verfahren nach Anspruch 1, wobei der SOC-Fehlerbereich eine Fehleruntergrenze und eine Fehlerobergrenze aufweist;
der Schritt des (S105) Korrigierens des aktuellen SOC-Werts gemäß dem Größenverhältnis zwischen dem SOC-Fehlerbereich und dem aktuellen SOC-Wert aufweist:
Korrigieren des aktuellen SOC-Werts auf die Fehleruntergrenze für den Fall, dass der aktuelle SOC-Wert den SOC-Fehlerbereich überschreitet und der aktuelle SOC-Wert kleiner als die Fehleruntergrenze ist;
Korrigieren des aktuellen SOC-Werts auf die Fehlerobergrenze für den Fall, dass der aktuelle SOC-Wert den SOC-Fehlerbereich überschreitet und der aktuelle SOC-Wert größer als die Fehlerobergrenze ist; und
Belassen des aktuellen SOC-Werts als nicht korrigiert für den Fall, dass der aktuelle SOC-Wert innerhalb des SOC-Fehlerbereichs liegt.

5. Verfahren nach Anspruch 4, wobei der Schritt des (S105) Korrigierens des aktuellen SOC-Werts gemäß dem Größenverhältnis zwischen dem SOC-Fehlerbereich und dem aktuellen SOC-Wert ferner aufweist:
Berechnen eines Mittelwerts des aktuellen SOC-Werts und der Fehleruntergrenze für den Fall, dass der aktuelle SOC-Wert den SOC-Fehlerbereich überschreitet, der aktuelle SOC-Wert kleiner als die Fehleruntergrenze ist und eine Differenz zwischen dem aktuellen SOC-Wert und der Fehleruntergrenze größer als eine erste voreingestellte Fehlerdifferenz ist, und Korrigieren des aktuellen SOC-Werts unter Verwendung des Mittelwerts; und
Berechnen eines Mittelwerts des aktuellen SOC-Werts und der Fehlerobergrenze für den Fall, dass der aktuelle SOC-Wert den SOC-Fehlerbereich überschreitet, der aktuelle SOC-Wert größer als die Fehlerobergrenze ist und eine Differenz zwischen dem aktuellen SOC-Wert und der Fehlerobergrenze größer als eine zweite voreingestellte Fehlerdifferenz ist, und Korrigieren des aktuellen SOC-Werts unter Verwendung des Mittelwerts.

6. Verfahren nach Anspruch 5, wobei der Schritt des (S105) Korrigierens des aktuellen SOC-Werts gemäß dem Größenverhältnis zwischen dem SOC-Fehlerbereich und dem aktuellen SOC-Wert ferner aufweist:
Verkürzen einer Dauer der letzten N Abtastperioden einer aktuellen Abtastperiode für den Fall, dass die Differenz zwischen dem aktuellen SOC-Wert und der Fehleruntergrenze größer als die erste voreingestellte Fehlerdifferenz ist oder die Differenz zwischen dem aktuellen SOC-Wert und der Fehlerobergrenze größer als die zweite voreingestellte Fehlerdifferenz ist, wobei N eine natürliche Zahl größer null ist.

7. Elektronische Vorrichtung (100) zum Schätzen eines Ladezustands, SOC, einer Batterie, wobei die Vorrichtung (100) aufweist:
ein Aktueller-SOC-Wert-Erhaltungsmodul (110), eingerichtet zum Erhalten eines aktuellen SOC-Werts der Batterie;
ein Gemessene-Spannung-Erhaltungsmodul (120), eingerichtet zum Abtasten einer Spannung und eines Stroms der Batterie, um eine aktuell gemessene Spannung und einen aktuell gemessenen Strom der Batterie zu erhalten;
ein SOC-Zielwert-Berechnungsmodul (130), eingerichtet zum Berechnen eines SOC-Zielwerts der Batterie bei der aktuell gemessenen Spannung;
ein SOC-Fehlerbereich-Bestimmungsmodul (140), eingerichtet zum Erhalten eines Korrekturfehlers des SOC-Zielwerts und Bestimmen des SOC-Fehlerbereichs auf Grundlage des Korrekturfehlers und des SOC-Zielwerts; und
ein SOC-Korrekturmodul (150), eingerichtet zum Korrigieren des aktuellen SOC-Werts gemäß einem Größenverhältnis zwischen einem SOC-Fehlerbereich und dem aktuellen SOC-Wert,
**dadurch gekennzeichnet, dass**
das SOC-Fehlerbereich-Bestimmungsmodul (140) eine Korrekturfehler-Erhaltungseinheit aufweist, die eingerichtet ist zum:
Erhalten von wahren SOC-Werten der Batterie bei verschiedenen gemessenen Spannungen, die durch Offline-Kalibrierung erhalten werden;
Erhalten von historischen SOC-Zielwerten der Batterie, die verschiedenen gemessenen Spannungen in historischen Lade- und Entladezyklen entsprechen;
für jede der gemessenen Spannungen, Heranziehen einer Differenz zwischen jedem der historischen SOC-Zielwerte und jedem der wahren SOC-Werte der Batterie bei der gemessenen Spannung als Fehlerwert entsprechend der gemessenen Spannung; und
Mitteln des Fehlerwerts entsprechend jeder gemessenen Spannung, um den Korrekturfehler des SOC-Zielwerts zu erhalten.

8. Elektronische Vorrichtung (100) nach Anspruch 7, wobei das SOC-Zielwert-Berechnungsmodul (130) insbesondere für eines von (a) und (b) eingerichtet ist:
(a) Berechnen einer Leerlaufspannung, OCV, der Batterie gemäß einer Formel *U_{ocv}=U_{c}+i*DCR,* wobei U_{OCV} die OCV repräsentiert, *U_{c}* die aktuell gemessene Spannung repräsentiert, *i* den aktuell gemessenen Strom der Batterie repräsentiert und *DCR* einen Gleichstrom-Innenwiderstand der Batterie repräsentiert; und Bestimmen eines SOC-Werts, der der OCV entspricht, auf Grundlage einer OCV-SOC-Entsprechungsbeziehung und Heranziehen des SOC-Werts als den SOC-Zielwert; und
(b) Bestimmen des SOC-Zielwerts, der der aktuell gemessenen Spannung entspricht, gemäß einer voreingestellten CCV-SOC-Tabelle für den Fall, dass sich die Batterie in einem Ladezustand befindet, wobei die voreingestellte CCV-SOC-Tabelle eine Entsprechungsbeziehung zwischen der gemessenen Spannung unter Last, CCV, und dem SOC-Wert aufweist.

9. Elektronische Vorrichtung (100) nach Anspruch 7, wobei der SOC-Fehlerbereich eine Fehleruntergrenze und eine Fehlerobergrenze aufweist;
das SOC-Korrekturmodul insbesondere eingerichtet ist zum:
Korrigieren des aktuellen SOC-Werts auf die Fehleruntergrenze für den Fall, dass der aktuelle SOC-Wert den SOC-Fehlerbereich überschreitet und der aktuelle SOC-Wert kleiner als die Fehleruntergrenze ist;
Korrigieren des aktuellen SOC-Werts auf die Fehlerobergrenze für den Fall, dass der aktuelle SOC-Wert den SOC-Fehlerbereich überschreitet und der aktuelle SOC-Wert größer als die Fehlerobergrenze ist; und
Belassen des aktuellen SOC-Werts als nicht korrigiert für den Fall, dass der aktuelle SOC-Wert innerhalb des SOC-Fehlerbereichs liegt.

10. Fahrzeug, mit der elektronischen Vorrichtung (100) nach einem der Ansprüche 7-9.

## Revendications

1. Procédé pour estimer un état de charge, SOC, d'une batterie exécuté par un dispositif électronique, le procédé comprenant :
(S101) l'obtention d'une valeur de SOC courante de la batterie ;
(S102) l'échantillonnage d'une tension et d'un courant de la batterie afin d'obtenir une tension mesurée courante et un courant mesuré courant de la batterie ;
(S103) le calcul d'une valeur cible de SOC de la batterie à la tension mesurée courante ;
(S104) l'obtention d'une erreur de correction de la valeur cible de SOC et la détermination de la plage d'erreur de SOC sur la base de l'erreur de correction et de la valeur cible de SOC ; et
(S105) la correction de la valeur de SOC courante conformément à une relation dimensionnelle entre une plage d'erreur de SOC et la valeur de SOC courante ;
**caractérisé en ce que** :
l'étape (S104) d'obtention d'une erreur de correction de la valeur cible de SOC comprend :
l'obtention de valeurs de SOC vraies de la batterie à des tensions mesurées différentes qui sont obtenues par étalonnage hors-ligne ;
l'obtention de valeurs cibles de SOC historiques de la batterie à des tensions mesurées différentes lors de cycles de charge et de décharge historiques ;
pour l'une quelconque des tensions mesurées, la considération d'une différence entre chacune des valeurs cibles de SOC historiques et chacune des valeurs de SOC vraies de la batterie aux tensions mesurées en tant que valeur d'erreur à la tension mesurée ; et
le calcul de la moyenne de la valeur d'erreur à chaque tension mesurée afin d'obtenir l'erreur de correction de la valeur cible de SOC.

2. Procédé selon la revendication 1, dans lequel l'étape (S103) de calcul de la valeur cible de SOC de la batterie à la tension mesurée courante comprend un ensemble d'opérations parmi (a) et (b) :
(a) le calcul d'une tension en circuit ouvert, OCV, de la batterie conformément à une formule *U_{ocv} = U_{c} + i* * DCR dans laquelle *U_{OCV}* représente l'OCV, *U_{C}* représente la tension mesurée courante, *i* représente le courant mesuré courant de la batterie et *DCR* représente une résistance interne en circuit direct de la batterie ; et la détermination d'une valeur de SOC à l'OCV sur la base d'une relation de correspondance OCV-SOC, et la considération de la valeur de SOC en tant que valeur cible de SOC ; et
(b) la détermination de la valeur cible de SOC pour la tension mesurée courante conformément à une table CCV-SOC prédéfinie dans le cas où la batterie est dans un état de charge, dans lequel la table CCV-SOC prédéfinie comprend une relation de correspondance entre la tension en circuit fermé mesurée, CCV, et la valeur de SOC.

3. Procédé selon la revendication 1, dans lequel l'étape de détermination de la plage d'erreur de SOC comprend :
l'obtention d'une limite inférieure d'erreur de la plage d'erreur de SOC en soustrayant l'erreur de correction de la valeur cible de SOC ; et
l'obtention d'une limite supérieure d'erreur de la plage d'erreur de SOC en ajoutant l'erreur de correction à la valeur cible de SOC.

4. Procédé selon la revendication 1, dans lequel la plage d'erreur de SOC comprend une limite inférieure d'erreur et une limite supérieure d'erreur ;
l'étape (S105) de correction de la valeur de SOC courante conformément à la relation dimensionnelle entre la plage d'erreur de SOC et la valeur de SOC courante comprend :
la correction de la valeur de SOC courante selon la limite inférieure d'erreur dans le cas où la valeur de SOC courante excède la plage d'erreur de SOC et la valeur de SOC courante est inférieure à la limite inférieure d'erreur ;
la correction de la valeur de SOC courante selon la limite supérieure d'erreur dans le cas où la valeur de SOC courante excède la plage d'erreur de SOC et la valeur de SOC courante est supérieure à la limite supérieure d'erreur ; et
le fait de laisser la valeur de SOC courante non corrigée dans le cas où la valeur de SOC courante est à l'intérieur de la plage d'erreur de SOC.

5. Procédé selon la revendication 4, dans lequel l'étape (S105) de correction de la valeur de SOC courante conformément à la relation dimensionnelle entre la plage d'erreur de SOC et la valeur de SOC courante comprend en outre :
le calcul d'une valeur moyenne de la valeur de SOC courante et de la limite inférieure d'erreur dans le cas où la valeur de SOC courante excède la plage d'erreur de SOC, la valeur de SOC courante est inférieure à la limite inférieure d'erreur et une différence entre la valeur de SOC courante et la limite inférieure d'erreur est supérieure à une première différence d'erreur prédéfinie, et la correction de la valeur de SOC courante en utilisant la valeur moyenne ; et
le calcul d'une valeur moyenne de la valeur de SOC courante et de la limite supérieure d'erreur dans le cas où la valeur de SOC courante excède la plage d'erreur de SOC, la valeur de SOC courante est supérieure à la limite supérieure d'erreur et une différence entre la valeur de SOC courante et la limite supérieure d'erreur est supérieure à une seconde différence d'erreur prédéfinie, et la correction de la valeur de SOC courante en utilisant la valeur moyenne.

6. Procédé selon la revendication 5, dans lequel l'étape (S105) de correction de la valeur de SOC courante conformément à la relation dimensionnelle entre la plage d'erreur de SOC et la valeur de SOC courante comprend en outre :
le raccourcissement d'une durée de N dernières périodes d'échantillonnage d'une période d'échantillonnage courante dans le cas où la différence entre la valeur de SOC courante et la limite inférieure d'erreur est supérieure à la première différence d'erreur prédéfinie, ou dans le cas où la différence entre la valeur de SOC courante et la limite supérieure d'erreur est supérieure à la seconde différence d'erreur prédéfinie, dans lequel N est un nombre naturel supérieur à zéro.

7. Dispositif électronique (100) pour estimer un état de charge, SOC, d'une batterie, le dispositif (100) comprenant :
un module d'obtention de valeur de SOC courante (110), configuré pour obtenir une valeur de SOC courante de la batterie ;
un module d'obtention de tension mesurée (120), configuré pour échantillonner une tension et un courant de la batterie afin d'obtenir une tension mesurée courante et un courant mesuré courant de la batterie ;
un module de calcul de valeur cible de SOC (130), configuré pour calculer une valeur cible de SOC de la batterie à la tension mesurée courante ;
un module de détermination de plage d'erreur de SOC (140), configuré pour obtenir une erreur de correction de la valeur cible de SOC, et pour déterminer la plage d'erreur de SOC sur la base de l'erreur de correction et de la valeur cible de SOC ; et
un module de correction de SOC (150), configuré pour corriger la valeur de SOC courante conformément à une relation dimensionnelle entre une plage d'erreur de SOC et la valeur de SOC courante,
**caractérisé en ce que** :
le module de détermination de plage d'erreur de SOC (140) comprend une unité d'obtention d'erreur de correction configurée pour :
obtenir des valeurs de SOC vraies de la batterie à des tensions mesurées différentes qui sont obtenues par étalonnage hors-ligne ;
obtenir des valeurs cibles de SOC historiques de la batterie qui correspondent à des tensions mesurées différentes lors de cycles de charge et de décharge historiques ;
pour l'une quelconque des tensions mesurées, considérer une différence entre chacune des valeurs cibles de SOC historiques et chacune des valeurs de SOC vraies de la batterie à la tension mesurée en tant que valeur d'erreur qui correspond à la tension mesurée ; et
calculer la moyenne de la valeur d'erreur qui correspond à chaque tension mesurée afin d'obtenir l'erreur de correction de la valeur cible de SOC.

8. Dispositif électronique (100) selon la revendication 7, dans lequel le module de calcul de valeur cible de SOC (130) est spécifiquement configuré pour effectuer un ensemble d'opérations parmi (a) et (b) :
(a) le calcul d'une tension en circuit ouvert, OCV, de la batterie conformément à une formule *U_{ocv} = U_{c} + i* * DCR dans laquelle *U_{OCV}* représente l'OCV, *U_{C}* représente la tension mesurée courante, *i* représente le courant mesuré courant de la batterie et DCR représente une résistance interne en circuit direct de la batterie ; et la détermination d'une valeur de SOC qui correspond à l'OCV sur la base d'une relation de correspondance OCV-SOC, et la considération de la valeur de SOC en tant que valeur cible de SOC ; et
(b) la détermination de la valeur cible de SOC pour la tension mesurée courante conformément à une table CCV-SOC prédéfinie dans le cas où la batterie est dans un état de charge, dans lequel la table CCV-SOC prédéfinie comprend une relation de correspondance entre la tension en circuit fermé mesurée, CCV, et la valeur de SOC.

9. Dispositif électronique (100) selon la revendication 7, dans lequel la plage d'erreur de SOC comprend une limite inférieure d'erreur et une limite supérieure d'erreur ;
le module de correction de SOC est spécifiquement configuré pour :
corriger la valeur de SOC courante selon la limite inférieure d'erreur dans le cas où la valeur de SOC courante excède la plage d'erreur de SOC et la valeur de SOC courante est inférieure à la limite inférieure d'erreur ;
corriger la valeur de SOC courante selon la limite supérieure d'erreur dans le cas où la valeur de SOC courante excède la plage d'erreur de SOC et la valeur de SOC courante est supérieure à la limite supérieure d'erreur ; et
laisser la valeur de SOC courante non corrigée dans le cas où la valeur de SOC courante est à l'intérieur de la plage d'erreur de SOC.

10. Véhicule, comprenant le dispositif électronique (100) selon l'une quelconque des revendications 7 à 9.
